# EUROPEAN PATENT SPECIFICATION

(11) **EP 2 259 353 B1**
(45) Date of publication and mention of the grant of the patent: **27.06.2012**
(21) Application number: 09734566.4
(22) Date of filing: 15.04.2009
(51) Int. Cl.: H01L 41/047, H01L 41/083

(54) **MULTILAYER PIEZOELECTRIC ACTUATOR**
MEHRSCHICHTIGER PIEZOELEKTRISCHER AKTUATOR
ACTIONNEUR PIÉZO-ÉLECTRIQUE MULTICOUCHE

(30) Priority: 21.04.2008 JP 2008110040
(43) Date of publication of application: 08.12.2010
(73) Proprietor: Murata Manufacturing Co. Ltd., Kyoto 617-8555 (JP)
(72) Inventor: KASAI, Shigeharu, Nagaokakyo-shi Kyoto 617-8555 (JP); SHINDO, Satoshi, Nagaokakyo-shi Kyoto 617-8555 (JP); HAYASHI, Koichi, Nagaokakyo-shi Kyoto 617-8555 (JP); MORIMOTO, Yasuhiro, Nagaokakyo-shi Kyoto 617-8555 (JP)
(74) Representative: Zimmermann, Tankred Klaus
(86) International application number: PCT/JP2009/001741
(87) International publication number: WO 2009/130863

(56) References cited:
- EP-A1- 1 753 039
- WO-A1-2007/114002
- DE-A1-102004 015 574
- DE-A1-102006 006 077
- JP-A- 2006 303 319
- JP-A- 2007 189 099
- JP-T- 2002 542 630
- US-A1- 2008 007 144
- US-B1- 6 794 800

## Description

### Technical Field

The present invention relates to multilayer piezoelectric actuators used as for example driving sources in automobile fuel-injection devices and more specifically relates to multilayer piezoelectric actuators in which external electrodes formed on external surfaces of a multilayer piezoelectric body each include a stress-absorbing external-electrode member that relaxes stress arising due to lengthening of the multilayer piezoelectric body.

### Background Art

With multilayer piezoelectric actuators, a large displacement is obtained but a large stress also arises in the piezoelectric body thereof. A multilayer piezoelectric actuator includes an active portion, in which a plurality of internal electrodes connected to different potentials are stacked on top of one another with piezoelectric layers therebetween; and a non-active portion positioned on the outside of the active portion in the stacking direction. When driving is performed, a voltage is not applied to the piezoelectric layers of the non-active portion. Therefore, when driving is performed, a large stress arises between the active portion, which lengthens due to the piezoelectric effect, and the non-active portion and thereby cracks sometimes occur in the piezoelectric body.

If such cracks progress and reach an external electrode formed on the surface of the piezoelectric body, there is a risk of the external electrode splitting. If the external electrode splits, there is a risk of a discharge occurring between split portions of the external electrode and of the multilayer piezoelectric body becoming damaged as a result.

Accordingly, in order to prevent the multilayer piezoelectric body from being damaged, a variety of structures have been proposed. For example, a multilayer piezoelectric actuator illustrated in Fig. 11 is disclosed in below-listed PTL 1. As illustrated in Fig. 11, in a multilayer piezoelectric actuator 101, a plurality of first internal electrodes 103 and a plurality of second internal electrodes 104 are alternately stacked on top of one another with piezoelectric layers therebetween in a multilayer piezoelectric body 102. The second internal electrodes 104 are led out to a side surface 102a. An external electrode 105 is formed on the side surface 102a. The external electrode 105 includes a metal base covering layer 105a formed on the side surface 102a, and an electrode member 105b that has a three-dimensional structure and is arranged on the metal base covering layer 105a. The electrode member 105b, which has a three-dimensional structure, is bonded to the metal base covering layer 105a at a plurality of contact portions through conductive bonding members 106.

For example, even in the case where a crack A occurs in the multilayer piezoelectric body 102 and the crack A reaches the side surface 102a, thereby splitting the metal base covering layer 105a, conduction is ensured by the electrode member 105b having a three-dimensional structure. Furthermore, the electrode member 105b, which has a three-dimensional structure, can absorb stress in the case where a stress has arisen causing the crack A. Therefore, with the electrode member 105b, the electrode is not likely to split.

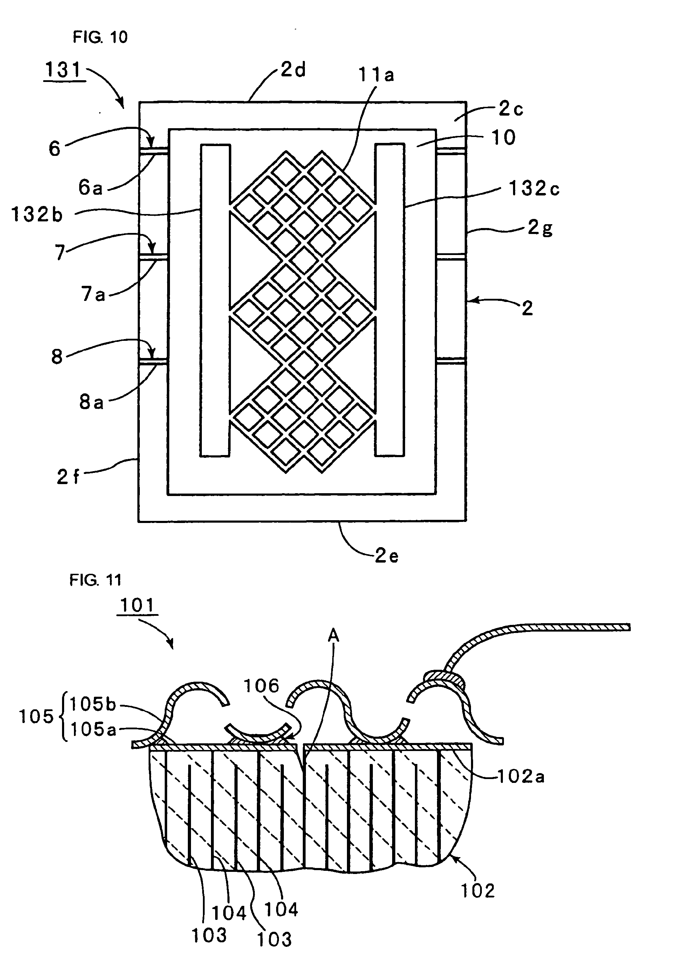

In PTL 1, such an electrode member 105b having a three-dimensional shape is not limited to having the shape illustrated in Fig. 11 and structures that employ a sponge metal or a metal mesh are also illustrated.

On the other hand, in below-listed PTL 2 and PTL 3, structures are disclosed in which a reinforcement external-electrode member, which is composed of a metal mesh, is stacked on a base electrode.

### Citation List

### Patent Literature

PTL 1: Japanese Unexamined Patent Application Publication No. 10-229227
PTL 2: Japanese Unexamined Patent Application Publication No. 63-153870
PTL 3: Japanese Unexamined Patent Application Publication No. 2001-210884

In order to bond the electrode member 105b having a three-dimensional structure described in PTL 1, to the metal base covering layer 105a serving as a base, the conductive bonding members 106 are used. Furthermore, a reinforcement external-electrode member composed of a metal mesh as described in PTLs 2 and 3 similarly is also bonded to a base electrode through conductive bonding members.

Examples of a bonding method in which such conductive bonding members are employed include a bonding method in which a conductive adhesive is used and brazing and welding.

However, in the case where a conductive adhesive or the like is used, if the bonding strength is insufficient and thermal stress arises due to a change in temperature during use, there is a risk of the reinforcement external-electrode member becoming detached due to a difference in thermal expansion between the piezoelectric ceramic and the electrode member composed of a metal.

In addition, with brazing methods, sufficient bonding strength can be obtained through selection of the brazing material. However, there has been a risk of flux and the like remaining and therefore a risk of the reliability of the multilayer piezoelectric actuator being reduced.

In the case where a welding method is used, the bonding strength can be increased. However, the multilayer piezoelectric body is locally heated to a high temperature when welding is performed. Consequently, there has been a risk of micro-cracks occurring in the multilayer piezoelectric actuator due to thermal shock and of the multilayer piezoelectric actuator being damaged due to the micro-cracks.
US 6,794,800 B1 relates to a piezoelectric actuator, especially for actuating control valves or injection valves in motor vehicles, having an actuator body in the form of a multilayer laminate of layered plies of piezoelectric material and intervening metal or electrically conductive layers, acting as electrodes, which are contacted in alternation by metal outer electrodes, facing one another on the jacket side in the longitudinal direction of the actuator body, that are at least in the form of laminar electrode strips, and the outer electrodes are in contact with electric terminal leads for connecting the piezoelectric actuator to an electrical voltage. The piezoelectric actuator has on its outer electrodes additional electrodes that are in contact at a plurality of points, via narrow elastic feet, with the laminar electrode strips.

### Summary of the Invention

An object of the present invention is to provide a multilayer piezoelectric actuator that solves the above-described drawbacks of the background art, is excellent in terms of reliability, includes an external electrode in which an electrode member for absorbing stress is bonded onto a base electrode, in which the bonding strength between the base electrode and the stress-absorbing electrode member is sufficiently high and in which the multilayer piezoelectric body is not likely to be damaged even when the piezoelectric body is driven or experiences a thermal shock.

This object is achieved by an actuator of claim 1.
A multilayer piezoelectric actuator according to the present invention includes: a multilayer piezoelectric body in which a plurality of internal electrodes and a plurality of piezoelectric layers are stacked on top of one another and in which the plurality of internal electrodes includes a first internal electrode and a second internal electrode connected to different potentials; and first and second external electrodes electrically respectively connected to the first and second internal electrodes and formed on external surfaces of the multilayer piezoelectric body. The multilayer piezoelectric body has first and second side surfaces that face each other, the first and second internal electrodes are respectively led out to the first and second side surfaces, and the first and second external electrodes are respectively formed on the first and second side surfaces. The first and second external electrodes each include a base electrode and a stress-absorbing external-electrode member. The base electrode is formed on the side surface of the piezoelectric body and is electrically connected to an edge portion of the first or second internal electrode led out to the side surface. The stress-absorbing external-electrode member is formed on the base electrode and includes an elastic structure that elastically deforms when subject to an external force and a fixed portion that is continuous with the elastic structure, extends parallel to the internal electrode edge portion positioned beneath the base electrode, and is bonded to the base electrode.

According to the present invention, the fixed portion is formed such that a portion thereof that is bonded to the base electrode has a width dimension that does not reach an internal electrode adjacent thereto in a stacking direction of the multilayer piezoelectric body. In this case, even when a crack has occurred, since the crack does not extend between the first and second internal electrodes connected to different potentials, it is not likely that a short circuit will occur between the first and second internal electrodes.

In a specific aspect of the multilayer piezoelectric actuator according to the present invention, the stress-absorbing external-electrode member is bonded to the base electrode at the fixed portion and the elastic structure is not bonded to the base electrode. In this case, since the elastic structure readily deforms when stress arises, stress that arises can be more effectively absorbed.

According to the present invention, the fixed portion includes first and second fixed portions and is arranged such that the first and second fixed portions oppose each other with the elastic structure sandwiched therebetween. When the first and second fixed portions are arranged so as to oppose each other with the elastic structure sandwiched therebetween in this manner, the stress-absorbing electrode member can be securely fixed to the base electrode. Therefore, the reliability of the bond between the stress-absorbing electrode member and the base electrode can be increased.

In yet another specific aspect of the multilayer piezoelectric actuator according to the present invention, the base electrode and the stress-absorbing external-electrode member are bonded to each other by diffusion bonding. In this case, the base electrode and the stress-absorbing external-electrode member are strongly bonded to each other. Moreover, when performing the bonding, since it is not necessary to perform heating at a high temperature, it is also not likely that the reliability of the multilayer piezoelectric actuator will be thereby decreased.

It is preferable that the base electrode and the stress-absorbing external-electrode member be diffusion bonded to each other through an insert metal and that the insert metal and the metal that diffuses when the stress-absorbing external-electrode member is diffusion bonded be the same type of metal. In this case, since the insert metal and the metal that diffuses when diffusion bonding of the stress-absorbing external-electrode member is performed are the same type of metal, the stress-absorbing electrode member can be more securely bonded to the base electrode.

Furthermore, in yet another specific aspect of the present invention, the insert metal is composed of a conductive paste including a metal powder and a glass frit and the base electrode is formed by baking an electrode paste whose main component is a metal the same as that of the conductive paste. In this case, simultaneously with the process of applying and baking the base electrode, the insert metal can be formed by applying and baking the conductive paste.

### Advantageous Effects of Invention

In the multilayer piezoelectric actuator according to the present invention, the first and second external electrodes each include a base electrode and a stress-absorbing electrode member formed on the base electrode. The stress-absorbing electrode member has an elastic structure and therefore even when stress arises in the external electrode during driving, the stress is quickly absorbed by the stress-absorbing electrode member. Therefore, even when a split portion occurs in the external electrode, since a split is not likely to occur in the stress-absorbing electrode member, a discharge does not occur between split portions of the external electrode and therefore cracks are not likely to occur in the multilayer piezoelectric body due to such a discharge.

Therefore, according to the present invention, a multilayer piezoelectric actuator can be provided that is excellent in terms of reliability and in which, even when driving is repeatedly performed or heat shock arises, cracks and damage originating from such cracks are not likely to occur.

### Brief Description of Drawings

[Fig. 1] Figs. 1(a) and 1(b) are respectively a perspective view and a side view from a second side surface illustrating the exterior of a multilayer piezoelectric actuator according to a first embodiment of the present invention.
[Fig. 2] Fig. 2 is a perspective view for explaining a stress-absorbing electrode member of the multilayer piezoelectric actuator according to the first embodiment.
[Fig. 3] Fig. 3 is a partial cut-away front sectional view for explaining the state of a crack that has occurred in the multilayer piezoelectric actuator according to the first embodiment.
[Fig. 4] Fig. 4 is a partial cut-away sectional view for explaining the state of occurrence of a crack in a multilayer piezoelectric actuator prepared for comparison.
[Fig. 5] Fig. 5 is a side view of a multilayer piezoelectric actuator according to a second embodiment of the present invention.
[Fig. 6] Fig. 6 is a partial cut-away sectional view for explaining the structure of a bonded portion between a stress-absorbing electrode member and a base electrode in the multilayer piezoelectric actuator according to the second embodiment.
[Fig. 7] Fig. 7 is a perspective view for explaining a modified example of the elastic structure of the stress-absorbing electrode member.
[Fig. 8] Fig. 8 is a perspective view for explaining another modified example of the elastic structure of the stress-absorbing electrode member.
[Fig. 9] Fig. 9 is a side view for explaining a multilayer piezoelectric actuator prepared as a first comparative example.
[Fig. 10] Fig. 10 is a side view illustrating a multilayer piezoelectric actuator prepared as a second comparative example.
[Fig. 11] Fig. 11 is a partial cut-away front sectional view illustrating an example of a multilayer piezoelectric actuator of the background art.

### Description of Embodiments

Hereafter, the present invention will be made clear by describing specific embodiments of the present invention with reference to the drawings.

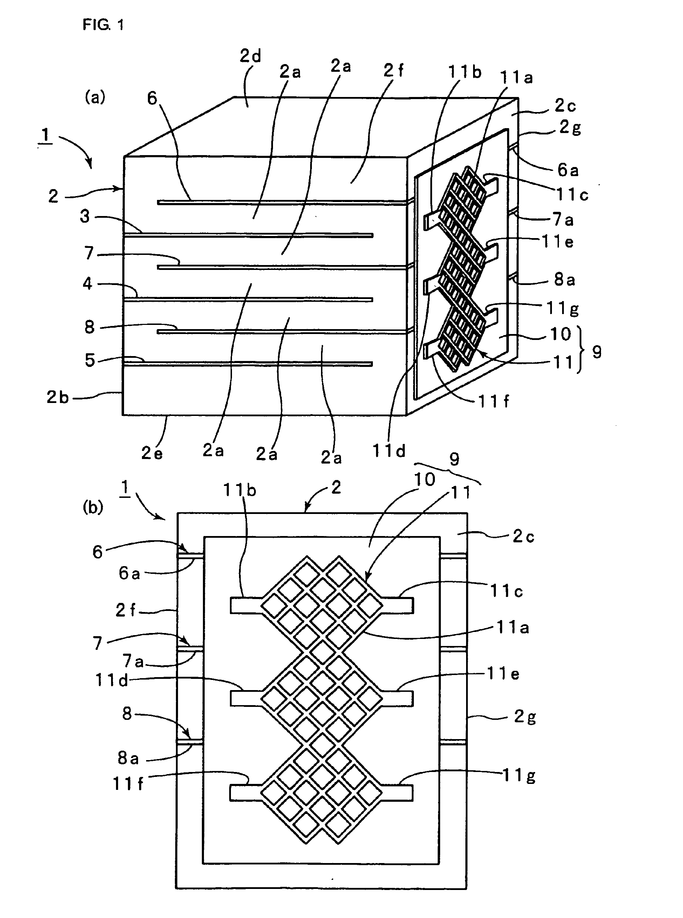

Fig. 1(a) and 1(b) are respectively a perspective view and a side view from a second side surface illustrating the exterior of a multilayer piezoelectric actuator according to a first embodiment of the present invention.

A multilayer piezoelectric actuator 1 includes a multilayer piezoelectric body 2. The multilayer piezoelectric body 2 is a monolithic piezoelectric body obtained by firing internal electrodes and a piezoelectric ceramic by using a co-firing technique.

In more detail, in the multilayer piezoelectric body 2, a plurality of first internal electrodes 3 to 5, which are connected to one potential, and second internal electrodes 6 to 8, which are connected to another potential different from that of the first internal electrodes, are alternately arranged in the stacking direction. The first internal electrodes 3 to 5 and the second internal electrodes 6 to 8 are arranged so as to overlap one another with piezoelectric layers 2a therebetween. In the multilayer piezoelectric body 2, the piezoelectric layers 2a are polarized in the thickness direction.

The first internal electrodes 3 to 5 are led out to a first side surface 2b of the multilayer piezoelectric body 2. In contrast, the plurality of second internal electrodes 6 to 8 are led out to a second side surface 2c, which is on the side opposite to the first side surface 2b.

An appropriate piezoelectric ceramic can be used as the piezoelectric material forming the multilayer piezoelectric body 2. Furthermore, the internal electrodes 3 to 8 are formed by co-sintering a conductive paste, such as Ag or Ag-Pd paste, and the piezoelectric ceramic.

The multilayer piezoelectric body 2 has a rectangular parallelepiped shape having the first and second side surfaces 2b and 2c, a top surface 2d and a bottom surface 2e, and a front surface 2f and a back surface 2g. A first external electrode is formed so as to be electrically connected to internal electrode edge portions of the first internal electrodes 3 to 5 led out to the side surface 2b. The first external electrode is not illustrated in Fig. 1(a).

Furthermore, a second external electrode 9 is formed on the second side surface 2c. The second external electrode 9 is electrically connected to internal electrode edge portions 6a to 8a of the second internal electrodes 6 to 8 led out to the side surface 2c.

In more detail, the external electrode 9 includes a base electrode 10 composed of a metal film formed on the side surface 2c and a stress-absorbing electrode member 11 bonded to the external surface of the base electrode 10. The first external electrode has the same structure.

The base electrode 10 can be formed by using a suitable metal such as Ag or Ag-Pd. The base electrode 10 is an electrode film formed by applying and then baking an electrode paste including the metal. However, the base electrode 10 may instead be formed by vapor deposition, plating or sputtering.

The stress-absorbing electrode member 11 includes an elastic structure 11a that elastically deforms when subject to an external force and first and second fixed portions 11b and 11c. In this embodiment, the first and second fixed portions 11b and 11c are arranged so as to oppose each other with the elastic structure 11a therebetween. The first and second fixed portions 11b and 11c are bonded to the base electrode 10. The elastic structure 11a is not bonded to the external surface of the base electrode 10. Therefore, since the elastic structure 11a is not bonded to the base electrode 10, when subject to an external force, the elastic structure 11a readily elastically deforms and absorbs the stress that has arisen, such that even when a stress arises, a split is not likely to occur in the elastic structure 11a.

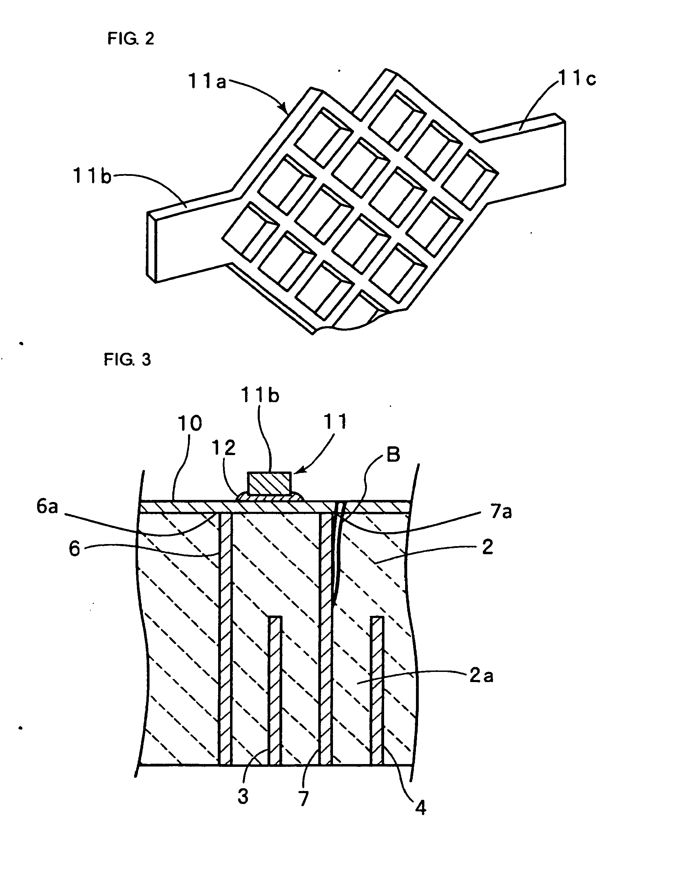

As illustrated in Fig. 2, the elastic structure 11a has a metal mesh-like shape. Therefore, even when an external force acts on the multilayer piezoelectric body 2 in the stacking direction or in a direction that intersects the stacking direction, the mesh-shaped portion readily elastically deforms. Thus, even when driving is repeatedly performed or heat shock arises, it is not likely that a split due to stress will occur in the elastic structure 11a.

On the other hand, the fixed portions 11b and 11c are each straight-line-shaped portions that extend parallel to the internal electrode edge portions 6a to 8a exposed at the side surface 2c beneath the base electrode 10. In this embodiment, the fixed portions 11b and 11c are provided so as not to overlap the internal electrode edge portions 6a and 7a with the base electrode 10 therebetween. However, the fixed portions 11b and 11c are not necessarily provided at positions that do not overlap the internal electrode edge portion 4a with the base electrode 10 therebetween.

In addition, the width-direction dimensions of bonded portions between the fixed portions 11b and 11c and the base electrode 10 do not reach the adjacent internal electrodes on both sides in the stacking direction of the multilayer piezoelectric body 2. Here, the term "width-direction dimension" is the dimension in a direction orthogonal to the direction in which the fixed portions 11b and 11c extend. More specifically, the width dimension of the fixed portions 11b and 11c is parallel to the stacking direction.

Moreover, the term "width-direction dimension", which is the width-direction dimension of portions of the fixed portions 11b and 11c, which are bonded to the base electrode 10, that does not reach the adjacent internal electrodes on both sides in the stacking direction, as illustrated in Fig. 3 more specifically means that the bonded portions between the fixed portions 11b and 11c and the base electrode formed by bonding members have a dimension that does not reach the internal electrode 6, which is the closest internal electrode, or the internal electrodes 7 adjacent to the internal electrode 6 on either side.

In addition, in the case where the fixed portions 11b and 11c are provided so as to be shifted from a position that overlaps the internal electrode edge portion 6a, for example in the case where they are arranged at a position between the internal electrode edge portion 6a and the internal electrode edge portion 7a, the bonded portions of the fixed portions 11b and 11c are made to have a width dimension such that they do not overlap the internal electrode 6 and the internal electrode 7 on both sides when viewed from the second side surface. In other words, this means that both the edge on the upper side and the edge on the lower side of each of the bonded portions in Fig. 3 are positioned at positions between the internal electrode 6 and the internal electrode 7.

In addition, first and second fixed portions 11d and 11e, and 11f and 11g are similarly arranged with respect to internal electrode edge portions 6a and 7a.

The stress-absorbing electrode member 11 can be formed from an Fe, Ni, Fe, Ni alloy or a suitable metal such as Cu or Ag.

In addition, as the method of bonding the fixed portions 11b to 11g to the base electrode 10, for example, a bonding method in which a conductive adhesive is used, brazing or welding, or a diffusion bonding method is used. In order that the bonding strength be sufficient and that there be no need to perform heating at a high temperature when performing the bonding, it is preferable that the bonding be performed by diffusion bonding.

However, it is also not likely that damage originating from cracks will occur in the multilayer piezoelectric actuator 1 according to this embodiment in the case where another bonding method is used.

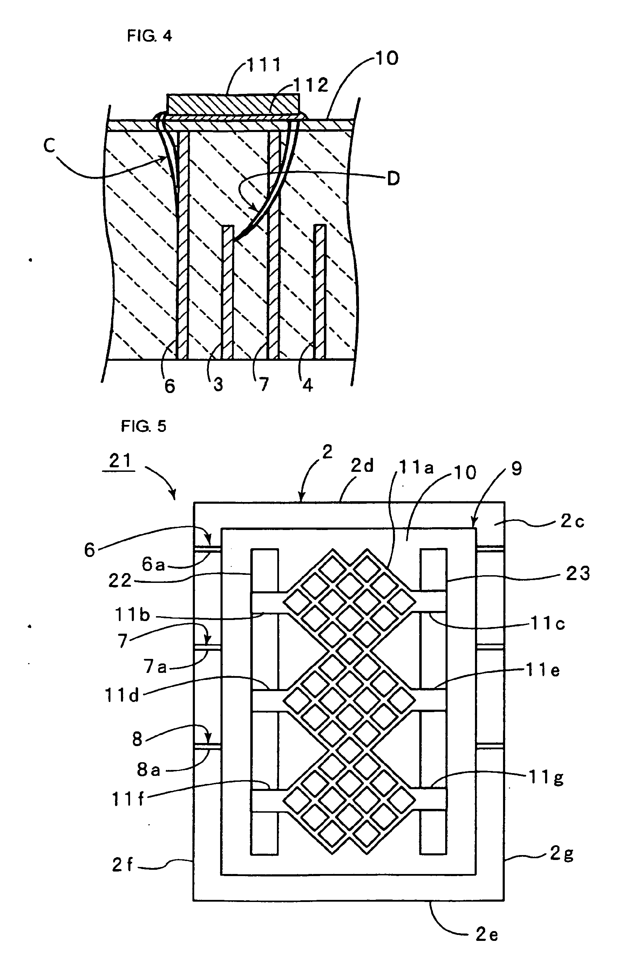

In this embodiment, since the first and second fixed portions 11b and 11c are formed so as to extend parallel to the internal electrode edge portion 6a and the width dimensions of the bonded portions of the fixed portions 11b and 11c are provided as described above, even if a crack occurs in the multilayer piezoelectric body 2, short circuits between the first internal electrodes and the second internal electrodes connected to different potentials are not likely to occur. This will be explained with reference to Fig. 3 and Fig. 4.

Fig. 3 is a schematic partial cut-away front sectional view illustrating a state in which a crack B has occurred in the multilayer piezoelectric actuator 1 of this embodiment.

In Fig. 3, the first fixed portion 11b extends parallel to the internal electrode edge portions 6a to 8a and is positioned between the internal electrodes 6 and 7.

A crack occurring in the multilayer piezoelectric body 2 usually starts from the boundary between an internal electrode, which is composed of a metal material, and a piezoelectric layer. As indicated by arrow B in Fig. 3, it is assumed that a crack has occurred that originates from the boundary between the second internal electrode 7 and a piezoelectric layer. The crack, as illustrated in Fig. 3, extends toward the side surface 2c of the multilayer piezoelectric body 2 and splits the base electrode 10. In this case, as described above, even when split portions occur in the base electrode 10, a discharge does not occur between the split portions due to the existence of the stress-absorbing electrode member 11 having the elastic structure 11a.

Furthermore, as illustrated in Fig. 3, the crack B has occurred at the boundary between the internal electrode 7 and the piezoelectric layer and extends without changing to the side surface 2c. Therefore, it is not likely that a short circuit will occur between the internal electrode 7 and the first internal electrodes 3 and 4.

This is due to the following reason.

Generally, boundaries between ceramic layers, that is, piezoelectric layers, and internal electrodes are the weakest parts in a ceramic multilayer body such as a multilayer piezoelectric body. Therefore, when a split due to stress or the like occurs, the split usually occurs at such a boundary. In such a case, the split occurs at the surface of the multilayer piezoelectric body. However, when a reinforcement external-electrode member is bonded to the outside of the base electrode, it is not likely that such a split will occur because of the reinforcement. However, in the case where bonded portions with which the reinforcement external-electrode member is bonded to the base electrode member are at positions that coincide with edge portions of the led-out internal electrodes, the reinforcement effect is increased and it becomes unlikely that splits will occur. In particular, in the case where the bonded portions extend over portions to which the internal electrodes of two or more adjacent layers are led out, splits are not likely to occur even when a considerable tensile stress arises. Conversely, in the case where relaxation of stress by a crack does not occur, the stress concentrates, and a split eventually occurs, cracks and splits come to randomly occur beyond the boundary. Consequently, the direction in which cracks occur cannot be controlled and a crack occurs that extends between the internal electrodes connected to different potentials.

As a result, the internal electrodes connected to different potentials are short-circuited and the withstand voltage is reduced due to the crack. In addition, the portion in which the crack has occurred is filled with air and therefore the dielectric constant thereof is low compared with that of the surrounding ceramic portion. Thus, it becomes likely that a discharge will occur due to the concentration of the electric field.

In contrast, in this embodiment, it is ensured that the width dimensions of the bonded portions of the fixed portions 11b and 11c do not extend between adjacent internal electrodes and as a result it can be ensured that cracks occur in the direction indicated by arrow B. In other words, although cracks are not prevented from occurring, even when a crack occurs, by controlling the direction in which the crack extends, splits and discharge can be prevented from occurring in random directions in the ceramic.

In contrast, in Fig. 4, a stress-absorbing electrode member 111 having only a mesh-shaped metal portion is bonded onto a base electrode with a bonding member 112 therebetween. The rest of the structure is the same as that of the multilayer piezoelectric actuator 1 of the above-described embodiment. Therefore, although only one cross section of the stress-absorbing electrode member 111 is illustrated in Fig. 4, in reality the stress-absorbing electrode member 111 extends in diagonal directions over the base electrode. Therefore, when cracks C and D progress toward bonded portions between the bonding member 112 and the stress-absorbing electrode member 111, there is a risk of a crack occurring that extends between the first internal electrode 3 and the second internal electrode 7, as with the crack D. Consequently, there is a risk of a short circuit occurring between the first internal electrode and the second internal electrode.

Even when a crack occurs, the crack extends toward a fixed portion and is not likely to extend in a diagonal direction from the boundary between a piezoelectric layer and an internal electrode in the multilayer piezoelectric body 2. Therefore, short circuits between the first and second internal electrodes can be prevented with certainty.

In Fig. 3, a part is illustrated where the fixed portion 11b is bonded to the base electrode 10 through a conductive bonding layer 12. In this embodiment, the conductive bonding layer 12 is a diffusion-bonding layer and is formed by performing heating in a state in which an insert metal has been interposed between the base electrode 10 and the fixed portion 11b so as to perform diffusion bonding.

When performing the diffusion bonding, the temperature at which heating is performed can be made to be a temperature that is comparatively low through selection of the metal to be diffused. Therefore, the risk of characteristics of the multilayer piezoelectric body 2 being degraded when diffusion bonding is performed is low. More desirably, it is preferable that the base electrode 10 be formed by applying and baking a conductive paste including a metal powder and that the same conductive paste be used as the insert metal layer for forming the conductive bonding layer 12 by diffusion bonding. In this case, formation of the base electrode 10 by baking and the diffusion bonding can be performed simultaneously. In other words, the following may be performed: the conductive paste is applied, the insert metal layer is then formed on the conductive paste by printing the same conductive paste thereon, then the fixed portion 11b of the stress-absorbing electrode member 11 is stacked thereon, and heating is performed at the firing temperature of the conductive paste. In this case, the process of forming both the base electrode 10 and forming the conductive bonding layer 12 can be performed by carrying out a heating process a single time. Therefore, the thermal stress that the multilayer piezoelectric body 2 is subjected to can be reduced. In addition, since the number of manufacturing steps is reduced, the cost can also be reduced.

Fig. 5 is a right side surface view of a multilayer piezoelectric actuator according to a second embodiment of the present invention and is a view that corresponds to Fig. 1(b) illustrating the first embodiment.

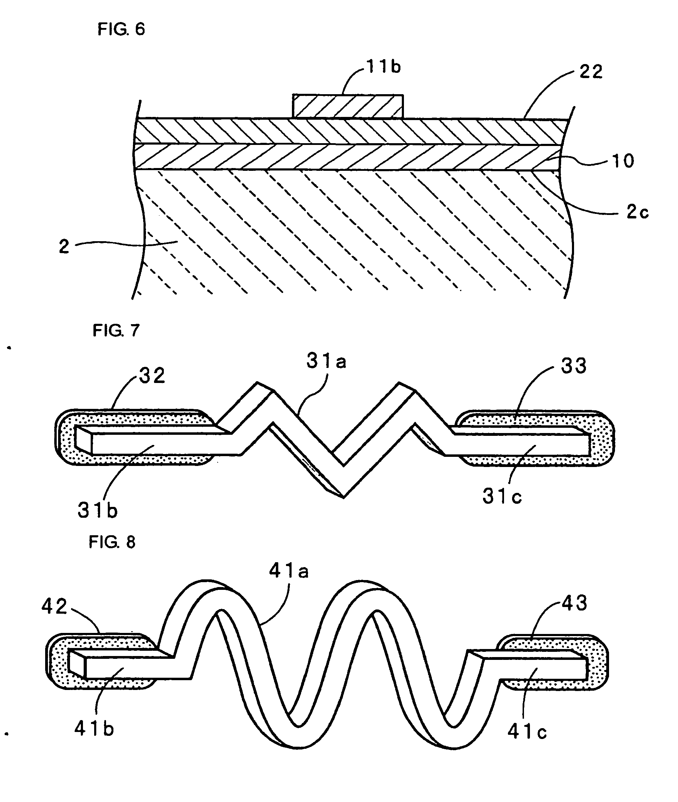

In a multilayer piezoelectric actuator 21 according to the second embodiment, on the side surface 2c of the multilayer piezoelectric body 2, metal layers 22 and 23 that extend in the stacking direction are formed on the base electrode 10. The metal layers 22 and 23 are formed by heating insert metal layers formed on the base electrode 10 so as to perform diffusion bonding. In other words, the first and second fixed portions 11b to 11g are diffusion bonded to the base electrode 10 by arranging the metal layers 22 and 23 on portions above which the fixed portions 11b to 11g are then arranged, and then performing heating, thereby performing diffusion bonding. As illustrated in the partial cut-away sectional view of Fig. 6, the first fixed portion 11b is diffusion bonded to the base electrode 10 through the metal layer 22. In this way, by forming the metal layer 22 that extends under the plurality of first fixed portions 11b, 11d and 11e and forming the strip-shaped metal layer 23 that extends under the plurality of second fixed portions 11c, 11e and 11g, positional determination can be simplified when performing diffusion bonding using an insert metal.

The rest of the structure of the multilayer piezoelectric actuator 21 according to the second embodiment is the same as that of the multilayer piezoelectric actuator 1 according to the first embodiment.

In addition, in these embodiments, the elastic structure 11a composed of a metal mesh is used, but the form of the elastic structure in the present invention is not limited to this. For example, as illustrated in Fig. 7, a zig-zag-shaped elastic structure 31a, which has a plurality of bent portions, may be provided between first and second fixed portions 31b and 31c. Here, the first and second fixed portions 31b and 31c are bonded onto the base electrode through conductive bonding members 32 and 33.

Furthermore, as illustrated in Fig. 8, a meandering-shaped, that is, wave-shaped, elastic structure 41a may be arranged between first and second fixed portions 41b and 41c.

The first and second fixed portions 41b and 41c are bonded to the base electrode through conductive adhesive portions 42 and 43.

In addition, Fig. 7 and Fig. 8 illustrate modified examples of an elastic structure and the zig-zag-shaped elastic structure 31a or the meandering-shaped elastic structure 41a may be formed in a plurality of lines between the first and second fixed portions.

Furthermore, it is to be noted that so long as stress can be absorbed, the shape of the elastic structure can deform in a variety of ways.

Next, it will be shown that the likelihood of damage or the like occurring due to cracks or the like is low and the resistance to heat shock is increased in the multilayer piezoelectric actuators according to the above-described embodiments by describing specific experimental examples.

First, a ceramic green sheet having a thickness of approximately 160 µm was formed using a ceramic slurry including a PZT piezoelectric ceramic powder, a resin binder and a plasticizer by employing a doctor blade method.

A conductive paste including Ag-Pd powder was printed onto one side of the ceramic green sheet by using a screen printing method. A plurality of the ceramic green sheets upon which the conductive paste had been printed were stacked on top of one another, and a plurality of plain ceramic green sheets were further stacked on both sides in the stacking direction. The thus-obtained multilayer body was subjected to pressing and the ceramic green sheets were compression bonded together. The thus-obtained multilayer body was cut into portions the size of target multilayer piezoelectric actuators, and thereby multilayer chips were obtained. By heating, binder treating and firing the multilayer chips, the multilayer piezoelectric body 2 was obtained. In the multilayer piezoelectric body 2, the distance between adjacent internal electrodes, that is, the thickness of a piezoelectric layer sandwiched between a pair of internal electrodes was made to be 100 µm.

In this way, a 10 mm x 10 mm multilayer piezoelectric body 2 with a dimension of 40 mm in the stacking direction was obtained.

Conductive paste having Ag as a main component was printed on the side surfaces 2b and 2c of the multilayer piezoelectric body 2. After being printed, the conductive paste was dried and then the same conductive paste was printed to serve as an insert metal for diffusion bonding. After that, the stress-absorbing electrode member was arranged on the base electrode. In this case, the conductive paste forming the insert metal layer was dried after ensuring that the elastic structure 11a did not contact the conductive paste forming the base electrode such that the first and second fixed portions 11b to 11g contacted the top of the conductive paste forming the insert metal.

Next, the base electrode was formed and diffusion bonding was performed by baking the conductive paste forming the base electrode and the insert metal layer in a furnace.

In addition, as for the stress-absorbing electrode member 11, processing was performed to form the shape of the elastic structure 11a and the fixed portions 11b to 11g illustrated in Figs. 1(a) and 1(b) by performing etching on an iron-nickel alloy. After the processing, silver having a thickness of 5 to 10 µm was formed on the surface by electroplating. In this way, the stress-absorbing electrode member 11 was formed and a multilayer piezoelectric actuator of a first example was obtained. The width direction dimension of the bonded portions between the fixed portions of the stress-absorbing electrode member 11 and the base electrode was made to be 100 µm and was thereby made to be a dimension that did not extend between adjacent internal electrodes.

In addition, as a second example, a multilayer piezoelectric actuator was prepared that was obtained in the same way as that of the first example, except that the stress-absorbing electrode member was bonded, not through diffusion bonding, but by using a conductive adhesive formed by mixing a silver powder into an epoxy adhesive.

As a third example, a multilayer piezoelectric actuator was prepared that was obtained in the same way as that of the first example, except that the stress-absorbing electrode member 11 was welded onto the base electrode 10 by resistance welding.

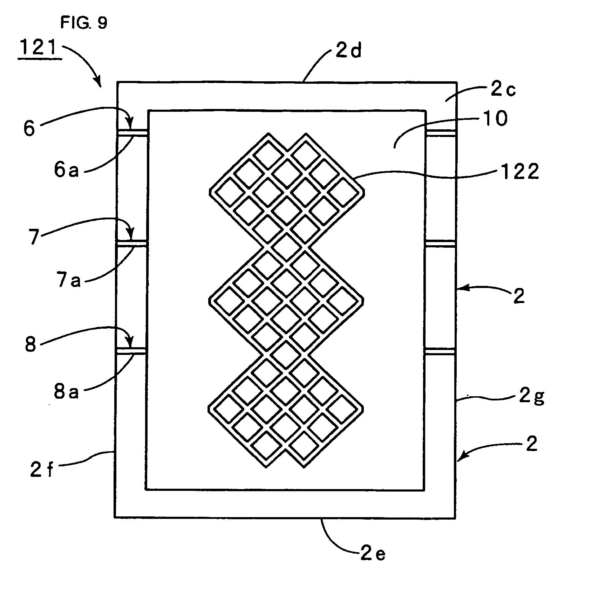

As a first comparative example, as illustrated in Fig. 9, a multilayer piezoelectric actuator 121 was prepared. In the multilayer piezoelectric actuator 121, a metal mesh-shaped stress-absorbing electrode member 122 was stacked on the base electrode 10 and the region around the edge of the stress-absorbing electrode member 122 served as a fixed portion. Therefore, the direction in which the fixed portion of the base electrode and the stress-absorbing electrode member extended was at an angle of substantially 45° relative to the internal electrode edge portions 6a to 8a.

In addition, as a second comparative example, as illustrated in Fig. 10, a multilayer piezoelectric actuator 131 was prepared that had a structure in which bonded portions at which fixed portions 132b and 132c are bonded to the base electrode 10 extend between adjacent internal electrode edge portions 6a and 7a and between internal electrode edge portions 7a and 8a. In other words, a multilayer piezoelectric actuator was prepared that had bonded portions structured the same as those illustrated in Fig. 4.

For each of the thus-prepared multilayer piezoelectric actuators, a silicone rubber layer was formed on the outer surface of the multilayer piezoelectric actuator by using a dipping method and the piezoelectric body was polarized by applying an electric field of 2kV/mm between the first and second external electrodes. In response to the polarization, the active portion lengthened and since the non-active portion did not lengthen a crack occurred due to the concentration of stress in all of the samples. The states of the cracks are illustrated in Table 1 below.

**[Table 1]**

| | Immediately After Bonding of Reinforcement Electrode | After Polarization |
|---|---|---|
| First Example | no cracks | crack parallel to internal electrode |
| Second Example | no cracks | crack parallel to internal electrode |
| Third Example | micro-crack | crack crossing over internal electrode |
| First Comparative Example | no cracks | crack crossing over internal electrode |
| Second Comparative Example | no cracks | crack crossing over internal electrode |

As is clear from Table 1, in the first example, no cracks could be recognized as having occurred immediately after the stress-absorbing electrode member had been bonded by diffusion bonding, but a crack occurred after polarization. As illustrated in Fig. 3, only a crack that extended parallel to an internal electrode occurred.

In contrast, in the first and second comparative examples and the second example, no cracks could be recognized as having occurred immediately after bonding of the stress-absorbing electrode member, but in the first and second comparative examples, after the polarization, a crack occurred that crossed over an internal electrode. In addition, in the second example, a crack that extended parallel to an internal electrode occurred.

On the other hand, in the third example, immediately after bonding of the stress-absorbing electrode member, a micro-crack could be recognized as having occurred and furthermore a crack that crossed between adjacent internal electrodes could be recognized as having occurred after the polarization.

In the first and second comparative examples, the occurrence of a crack that crossed between internal electrodes connected to different potentials is considered to be due to a crack occurring that extended toward to a bonded portion between the base electrode and the stress-absorbing electrode member and extended between internal electrodes connected to different potentials.

Therefore, compared with the first and second comparative examples, it is clear that the first and second examples are preferable since no cracks that crossed between internal electrodes connected to different potentials occurred.

Furthermore, in the third example, although a micro-crack occurred, large cracks, such as in the first and second comparative examples, did not occur. In the third example, it is thought that the micro-crack occurred due to local heating caused by the welding.

Next, a rectangular wave of 0 - 200 V was applied to each of the multilayer piezoelectric actuators of the first to third examples and the first and second comparative examples in an environment of 60 °C and having a relative humidity of 50% and the number of times driving was performed until breakdown occurred was measured. The results are illustrated in Table 2 below.

**[Table 2]**

| | No. of Times Driving Was Performed Until Breakdown |
|---|---|
| First Example | driving performed 10⁹ times or more with no breakdown |
| Second Example | driving performed 10⁹ times or more with no breakdown |
| Third Example | driving performed 5 x 10⁸ times or above with no breakdown |
| First Comparative Example | driving performed 5 x 10⁸ times or less before breakdown in all samples |
| Second Comparative Example | driving performed 5 x 10⁸ times or less before breakdown in all samples |

As is clear from Table 2, in the first and second comparative examples, breakdown was recognized as having occurred after driving had been performed 10⁸ times or less. In contrast, in the first and second examples, even after driving had been performed 10⁹ times or more, breakdown had still not been recognized as having occurred. Furthermore, in the third example, even after driving had been performed 10⁸ times or more, breakdown had still not been recognized as having occurred.

In addition, in the third example, although breakdown was recognized as having occurred in some of the samples after driving had been performed 10⁹ times or less, hardly any cracks extending in a diagonal direction with respect to the direction of extension of the internal electrodes were recognized as having occurred. In contrast, in the first and second comparative examples, when breakdown occurred, a crack occurred in a diagonal direction with respect to the direction of extension of the internal electrodes and a discharge was recognized as having occurred.

Next, in order to check the bonding strength of the stress-absorbing electrode member, a thermal shock test was performed for 500 cycles, in a single cycle of which the multilayer piezoelectric actuators of the first and second examples were maintained at -40°C for sixty minutes, then were rapidly heated at a temperature of 150°C and then were maintained at a temperature of 150°C for sixty minutes.

The thermal shock test was performed for ten multilayer piezoelectric actuators for each of the first and second examples. Thereafter, the bonding state of the stress-absorbing electrode member was checked. In the first example, after the thermal shock test, no defects were recognized as having occurred in the bonding state of the stress-absorbing electrode member for all of the samples.

In contrast, in the second example, detachment of the stress-absorbing electrode member was recognized as having occurred for six out of the ten multilayer piezoelectric actuators.

In addition, after the thermal shock test, a driving test was conducted by applying a rectangular wave voltage of 200 V to the ten multilayer piezoelectric actuators of the first example and to the four multilayer piezoelectric actuators for which no detachment was recognized as having occurred out of the multilayer piezoelectric actuators of the second example. In the first example, driving was able to be normally performed with the ten multilayer piezoelectric actuators, even when driving was performed 1x10⁶ times. In contrast, in the second example, breakdown occurred due to detachment of the stress-absorbing electrode member for all of the four multilayer piezoelectric actuators.

### Reference Signs List

1... multilayer piezoelectric actuator
2...multilayer piezoelectric body
2a...piezoelectric layer
2b...first side surface
2c...second side surface
2d...top surface
2e...bottom surface
2f...front surface
2g...back surface
3 to 8...internal electrode
4a...internal electrode edge portion
6a to 8a...internal electrode edge portion
9...external electrode
10...base electrode
11...stress-absorbing electrode member
11a...elastic structure
11b to 11g...fixed portion
12...conductive bonding layer
21...multilayer piezoelectric actuator
22, 23...metal layer
31a...elastic structure
31b, 31c...fixed portion
32, 33...conductive bonding member
41a...elastic structure
41b, 41c...fixed portion
42, 43...conductive adhesive portion
101...multilayer piezoelectric actuator
102...multilayer piezoelectric body
102a...side surface
103...first internal electrode
104...second internal electrode
105...external electrode
105a...metal base covering layer
105b...electrode member
106...conductive bonding member
111...stress-absorbing electrode member
112...bonding member
121...multilayer piezoelectric actuator
122...stress-absorbing electrode member
122a...fixed portion
131...multilayer piezoelectric actuator
132b, 132c...fixed portion

## Claims

1. A multilayer piezoelectric actuator comprising:
a multilayer piezoelectric body (2) in which a plurality of internal electrodes (3-8) and a plurality of piezoelectric layers (2a) are stacked on top of one another and in which the plurality of internal electrodes includes a first internal electrode (3-5) and a second internal electrode (6-8) connected to different potentials; and
first and second (9) external electrodes respectively electrically connected to the first and second internal electrodes (3-8) and formed on external surfaces of the multilayer piezoelectric body (2);
wherein the multilayer piezoelectric body (2) has first and second opposite side surfaces (2b, 2c), the first and second internal electrodes (3-8) are respectively led out to the first and second side surfaces (2b, 2c), and the first and second external (9) electrodes are respectively formed on the first and second side surfaces (2b, 2c); and
wherein the first and second external electrodes each include a base electrode (10) and a stress-absorbing external-electrode member (11), the base electrode (10) is formed on the side surface (2c) of the piezoelectric body (2) and is electrically connected to an edge portion (6a-8a) of the first or second internal electrode (3-8) led out to the side surface (2c), the stress-absorbing external-electrode member (11) is formed on the base electrode (10) and includes an elastic structure (11a; 31a; 41a) that elastically deforms when subject to an external force and a plurality of pairs of fixed portions (11b-11g; 31b, 31c; 41b, 41c) that are connected to the elastic structure (11a; 31a; 41a), extend parallel to the internal electrode edge portion (6a-8a) positioned beneath the base electrode (10), and are bonded to the base electrode (10),
**characterized in that**
a pair of fixed portions (11b-11g; 31b, 31c; 41b, 41c) includes first and second fixed portions arranged such that the first and second fixed portions oppose each other with the elastic structure (11a; 31a; 41a) therebetween, and
a bonded portion (12; 32, 33; 42, 43) of the respective fixed portions (11b-11g; 31b, 31c; 41b, 41c)that is bonded to the base electrode (10) has a width dimension in a stacking direction of the multilayer piezoelectric body (2) such that, when viewed from the side face, the bonded portion (12; 32, 33; 42, 43) does not overlap both of neighboring internal electrodes (6, 7) connected to the base electrode (10) to which the bonded portion (12; 32, 33; 42, 43) is bonded.

2. The multilayer piezoelectric actuator according to Claim 1, wherein the elastic structure (11a; 31a; 41a) is not bonded to the base electrode (10).

3. The multilayer piezoelectric actuator according to Claim 1 or 2, wherein the base electrode (10) and the stress-absorbing external-electrode member (11) are bonded to each other by diffusion bonding.

4. The multilayer piezoelectric actuator according to Claim 3, wherein the base electrode (10) and the stress-absorbing external-electrode member (11) are diffusion bonded to each other through an insert metal (22,23), and the insert metal and the metal that diffuses when the stress-absorbing external-electrode member (11a; 31a; 41a) is diffusion bonded are the same type of metal.

5. The multilayer piezoelectric actuator according to Claim 4, wherein the insert metal (22, 23) is composed of a conductive paste including a metal powder and a glass frit, and the base electrode (10) is formed by firing an electrode paste whose main component is a metal the same as that of the conductive paste.

## Patentansprüche

1. Eine mehrschichtige piezoelektrische Betätigungsvorrichtung, die folgende Merkmale aufweist:
einen mehrschichtigen piezoelektrischen Körper (2), in dem eine Mehrzahl von inneren Elektroden (3-8) und eine Mehrzahl von piezoelektrischen Schichten (2a) aufeinander gestapelt sind, und in dem die Mehrzahl von inneren Elektroden eine erste innere Elektrode (3-5) und eine zweite innere Elektrode (6-8) umfasst, die mit unterschiedlichen Potenzialen verbunden sind; und
eine erste und eine zweite (9) äußere Elektrode, die jeweils elektrisch verbunden sind mit der ersten und zweiten inneren Elektrode (3-8) und auf äußeren Oberflächen des mehrschichtigen piezoelektrischen Körpers (2) gebildet sind;
wobei der mehrschichtige piezoelektrische Körper (2) eine erste und eine zweite gegenüberliegende Seitenoberfläche (2b, 2c) aufweist, wobei die erste und zweite innere Elektrode (3-8) jeweils herausgeführt sind zu der ersten und zweiten Seitenoberfläche (2b, 2c), und die erste und die zweite (9) äußere Elektrode jeweils auf der ersten und zweiten Seitenoberfläche (2b, 2c) gebildet sind; und
wobei die erste und die zweite äußere Elektrode jeweils eine Basiselektrode (10) und ein Stress absorbierendes Äußere-Elektrode-Bauglied (11) aufweisen, wobei die Basiselektrode (10) auf der Seitenoberfläche (2c) des piezoelektrischen Körpers (2) gebildet ist und elektrisch verbunden ist mit einem Randabschnitt (6a-8a) der ersten oder zweiten inneren Elektrode(3-8), die herausgeführt ist zu der Seitenoberfläche (2c), wobei das Stress absorbierende Äußere-Elektrode-Bauglied (11) auf der Basiselektrode (10) gebildet ist und eine elastische Struktur (11a; 31 a; 41 a), die sich elastisch verformt, wenn sie einer äußeren Kraft ausgesetzt ist, und eine Mehrzahl von Paaren von festen Abschnitten (11b- 11g; 31 b, 31 c; 41 b, 41 c) umfasst, die mit der elastischen Struktur (11a; 31 a; 41 a) verbunden sind, sich parallel zu dem Innere-Elektrode-Randabschnitt (6a-8a) erstrecken, der unter der Basiselektrode (10) positioniert ist, und mit der Basiselektrode (10) verbunden sind,
**dadurch gekennzeichnet, dass**
ein Paar von festen Abschnitten (11b-11g; 31b, 3 1 c; 41 b, 41 c) einen ersten und einen zweiten festen Abschnitt aufweist, die so angeordnet sind, dass der erste und der zweite feste Abschnitt einander gegenüberliegen mit der elastischen Struktur (11a; 31a; 41 a) zwischen denselben, und
ein verbundener Abschnitt (12; 32, 33; 42, 43) der jeweiligen festen Abschnitte (11b-11g; 31b, 31 c; 41 b, 41 c), der mit der Basiselektrode (10) verbunden ist, eine Breitenabmessung in einer Stapelrichtung des mehrschichtigen piezoelektrischen Körpers (2) aufweist, so dass, von der Seitenfläche aus gesehen, der verbundene Abschnitt (12; 32, 33; 42, 43) beide der benachbarten Innenelektroden (6, 7) nicht überlappt, die mit der Basiselektrode (10) verbunden sind, mit der der verbundene Abschnitt (12; 32, 33; 42, 43) verbunden ist.

2. Die mehrschichtige piezoelektrische Betätigungsvorrichtung gemäß Anspruch 1, bei der die elastische Struktur (11a; 31 a; 41 a) nicht mit der Basiselektrode (10) verbunden ist.

3. Die mehrschichtige piezoelektrische Betätigungsvorrichtung gemäß Anspruch 1 oder 2, bei der die Basiselektrode (10) und das Stress absorbierende Äußere-Elektrode-Bauglied (11) durch Diffusionsverbinden miteinander verbunden sind.

4. Die mehrschichtige piezoelektrische Betätigungsvorrichtung gemäß Anspruch 3, bei der die Basiselektrode (10) und das Stress absorbierende Äußere-Elektrode-Bauglied (11) diffusionsverbunden sind miteinander durch ein eingesetztes Metall (22, 23), und das eingesetzte Metall und das Metall, das diffundiert, wenn das Stress absorbierende Äußere-Elektrode-Bauglied (11a; 31a; 41a) diffusionsverbunden ist, der gleiche Metalltyp sind.

5. Die mehrschichtige piezoelektrische Betätigungsvorrichtung gemäß Anspruch 4, bei der das eingesetzte Metall (22, 23) aus einer leitfähigen Paste besteht, die ein Metallpulver und eine Glasfritte umfasst, und die Basiselektrode (10) gebildet ist durch Brennen einer Elektrodenpaste, deren Hauptkomponente ein Metall ist, das das gleiche ist wie dasjenige der leitfähigen Paste.

## Revendications

1. Actionneur piézoélectrique multicouche comprenant :
un corps piézoélectrique multicouche (2) dans lequel une pluralité d'électrodes internes (3 à 8) et une pluralité de couches piézoélectriques (2a) sont empilées les unes au-dessus des autres et dans lequel la pluralité d'électrodes internes comprend une première électrode interne (3 à 5) et une deuxième électrode interne (6 à 8) connectées à différents potentiels ; et
des première et deuxième (9) électrodes externes respectivement connectées électriquement aux première et deuxième électrodes (3 à 8) et formées sur les surfaces externes du corps piézoélectrique multicouche (2) ;
dans lequel le corps piézoélectrique multicouche (2) a des première et deuxième surfaces latérales (2b, 2c) opposées, les première et deuxième électrodes internes (3 à 8) sont respectivement sorties vers les première et deuxième surfaces latérales (2b, 2c), et les première et deuxième électrodes externes (9) sont respectivement formées sur les première et deuxième surfaces latérales (2b, 2c) ; et
dans lequel les première et deuxième électrodes externes comprennent chacune une électrode de base (10) et un élément d'électrode externe absorbant les contraintes (11), l'électrode de base (10) est formée sur la surface latérale (2c) du corps piézoélectrique (2) et est connectée électriquement à une partie de bord (6a à 8a) de la première ou de la deuxième électrode interne (3 à 8) sortie vers la surface latérale (2c), l'élément d'électrode externe absorbant les contraintes (11) est formé sur l'électrode de base (10) et comprend une structure élastique (11a ; 31a ; 41a) qui se déforme élastiquement lorsqu'elle est soumise à une force externe et une pluralité de paires de parties fixes (11b à 11g; 31b, 31c ; 41b, 41c) qui sont reliées à la structure élastique (11a ; 31a ; 41a), s'étendent parallèlement à la partie de bord d'électrode interne (6a à 8a) positionnée au-dessous de l'électrode de base (10), et qui sont liées à l'électrode de base (10),
**caractérisé en ce que**
une paire de parties fixes (11b à 11g ; 31b, 31c ; 41b, 41c) comprend des première et deuxième parties fixes agencées de sorte que les première et deuxième parties fixes soient opposées l'une à l'autre avec la structure élastique (11a ; 31a ; 41a) entre elles, et
une partie liée (12 ; 32, 33 ; 42, 43) des parties fixes (11b à 11g ; 31b, 31c ; 41b, 41c) respectives qui est liée à l'électrode de base (10) a une dimension en largeur dans une direction d'empilement du corps piézoélectrique multicouche (2) de sorte que, lorsqu'elle est vue à partir de la face latérale, la partie liée (12 ; 32, 33 ; 42, 43) ne chevauche pas les deux électrodes internes (6, 7) voisines connectées à l'électrode de base (10) à laquelle la partie liée (12 ; 32, 33 ; 42, 43) est liée.

2. Actionneur piézoélectrique multicouche selon la revendication 1, dans lequel la structure élastique (11a; 31a ; 41a) n'est pas liée à l'électrode de base (10).

3. Actionneur piézoélectrique multicouche selon la revendication 1 ou 2, dans lequel l'électrode de base (10) et l'élément d'électrode externe absorbant les contraintes (11) sont liés l'un à l'autre par une liaison par diffusion.

4. Actionneur piézoélectrique multicouche selon la revendication 3, dans lequel l'électrode de base (10) et l'élément d'électrode externe absorbant les contraintes (11) sont liés par diffusion l'un à l'autre par l'intermédiaire d'un insert métallique (22, 23), et l'insert métallique et le métal qui diffuse lorsque l'élément d'électrode externe absorbant les contraintes (11a ; 31a ; 41a) est lié par diffusion sont du même type de métal.

5. Actionneur piézoélectrique multicouche selon la revendication 4, dans lequel l'insert métallique (22, 23) est composé d'une pâte conductrice comprenant une poudre métallique et une fritte de verre, et l'électrode de base (10) est formée en cuisant une pâte d'électrode dont le composant principal est un métal identique à celui de la pâte conductrice.
